Europäisches Patentamt

European Patent Office

Office européen des brevets

(19)

(11) **EP 0 951 750 B1**

(12) **EUROPÄISCHE PATENTSCHRIFT**

(45) Veröffentlichungstag und Bekanntmachung des Hinweises auf die Patenterteilung:
**24.10.2001  Patentblatt 2001/43**

(51) Int Cl.⁷: **H03B 28/00**, G06G 7/22

(21) Anmeldenummer: **97953628.1**

(22) Anmeldetag: **17.12.1997**

(86) Internationale Anmeldenummer:
**PCT/DE97/02922**

(87) Internationale Veröffentlichungsnummer:
**WO 98/32219 (23.07.1998 Gazette 1998/29)**

(54) **VERFAHREN UND SCHALTUNGSANORDNUNG ZUR ERZEUGUNG VON SINUS-/COSINUSSCHWINGUNGEN**

METHOD AND CIRCUIT CONFIGURATION FOR PRODUCING SINUSOIDAL/COSINUSOIDAL OSCILLATIONS

PROCEDE ET CONFIGURATION DE CIRCUITS POUR LA GENERATION D'OSCILLATIONS SINUSOIDALES/COSINUSOIDALES

(84) Benannte Vertragsstaaten:
**AT BE CH DE DK ES FI FR GB GR IE IT LI LU MC NL PT SE**

(30) Priorität: **15.01.1997  DE 19701068**

(43) Veröffentlichungstag der Anmeldung:
**27.10.1999  Patentblatt 1999/43**

(73) Patentinhaber: **Deutsche Telekom AG 53113 Bonn (DE)**

(72) Erfinder: **HUBER, Klaus D-64283 Darmstadt (DE)**

(56) Entgegenhaltungen:
**US-A- 3 688 098          US-A- 5 132 636
US-A- 5 361 036**

• **PATENT ABSTRACTS OF JAPAN vol. 014, no. 580 (E-1017), 25.Dezember 1990 & JP 02 253704 A (INTAANITSUKUSU KK), 12.Oktober 1990,**

Anmerkung: Innerhalb von neun Monaten nach der Bekanntmachung des Hinweises auf die Erteilung des europäischen Patents  kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Erzeugung von Sinus-/Cosinusschwingungen nach dem Oberbegriff des Patentanspruches 1 und eine Schaltungsanordnung zur Durchführung des Verfahrens nach dem Oberbegriff des Patentanspruches 3.

Verfahren zur Erzeugung von Sinus- bzw. Cosinusschwingungen sind in der Nachrichtentechnik und in der Computertechnik für die verschiedensten Zwecke bekannt. Außerdem sind auch Schaltungsanordnungen bekannt, die die Sinus- und Cosinusschwingungen erzeugen. Verschiedene Möglichkeiten derartige Schwingungen zu erzeugen, sind in dem Buch von U. Tietze, Ch. Schenk, "Hableiterschaltungstechnik", Springer Verlag 1980, beschrieben. In der Nachrichtentechnik sind auch sogenannte Tschebyscheffsche Filter bekannt, die auf dem Tschebyscheffschen Polynom n-ten Grades, definiert durch

$$T_n(\cos(\varphi)) = \cos(n\varphi),$$

beruhen.

Die Tschebyscheffschen Polynome sind zum Beispiel beschrieben in I. Schur, "Arithmetisches über die Tschebyscheffschen Polynome", Gesammelte Abhandlungen Vol. III, Seiten 422 bis 453, Springer Verlag 1973.

Aus der US-A-5,132,636 ist ein Verfahren zum Erzeugen von Sinusschwingungen bekannt, wobei eine Dreieckschwingung an den Eingang eines programmierbaren oder festprogrammierten Schaltungsmoduls gegeben wird. Hierbei werden jedoch keine Tschebyscheffschen Polynome angewendet.

Der Erfindung liegt die Aufgabe zugrunde, ein Verfahren und eine Schaltungsanordnung zur Erzeugung von Sinus-/Cosinusschwingungen zu schaffen, die mit einfachen und leicht zu kombinierenden Bausteinen die Sinus-/Cosinusschwingungserzeugung in universeller und prinzipiell einfacher Weise in Modultechnik mit Hilfe der Tschebyscheffschen Polynome ermöglichen.

Die erfindungsgemäße Lösung für das Verfahren zur Erzeugung von Sinus-/Cosinusschwingungen ist im Kennzeichen des Patentanspruches 1 charakterisiert.

Die erfindungsgemäße Lösung für die Schaltungsanordnung zur Erzeugung von Sinus-/Cosinusschwingungen ist im Kennzeichen des Patentanspruches 3 charakterisiert.

Weitere Merkmale bzw. Ausgestaltungen der Erfindung sind in der Beschreibung, im Patentanspruch 2 für das Verfahren und in den Patentansprüchen 4 bis 6 für die Vorrichtung angegeben.

Das erfindungsgemäße Verfahren und die erfindungsgemäße Vorrichtung haben den Vorteil, daß sie zur Erzeugung von Sinus-/Cosinusschwingungen eine modulare Schaltungstechnik ermöglichen, indem Tschebyscheff Polynome in diesen Modulen implementiert sind. Dies ist insbesondere in der Halbleitertechnik durch entsprechende strukturierte Chips realisierbar. Die Tschebyscheffschen Polynome sowie die zur schaltungstechnischen Implementierung erforderlichen Multiplizierer, Summierer und Addierschaltungen lassen sich in integrierter Schaltungstechnik in Modulbauweise realisieren, wobei dann je nach äußerer Verdrahtung die unterschiedlichsten gewünschten Sinus-/Cosinusschwingungen von diesen Modulen erzeugt werden können. Derartige Bausteine in Modultechnik lassen sich durch die modularen Schaltungsstrukturen sehr leicht kombinieren und in bereits vorhandene Schaltungsstrukturen integrieren.

Die Erfindung wird im folgenden anhand von in der Zeichnung dargestellten Ausführungsbeispielen näher beschrieben. In der Beschreibung, in den Patentansprüchen, der Zusammenfassung und in der Zeichnung werden die in der hinten angeführten Liste der Bezugszeichen verwendeten Begriffe und die zugeordneten Bezugszeichen verwendet.

In der Zeichnung bedeuten:

Fig. 1      eine Schaltungsanordnung zur Realisierung von $T_{nm}(x)$ ;

Fig. 2      eine Schaltungsanordnung zur Realisierung von $T_{n+-m}(x)$ ;

Fig. 3      eine Schaltungsanordnung zur Realisierung von $T_2(x)$;

Fig. 4      eine Schaltungsanordnung zur Realisierung von $T_3(x)$ und

Fig. 5      eine Dreieckschwingung als Eingangsgröße für die genannten Schaltungen.

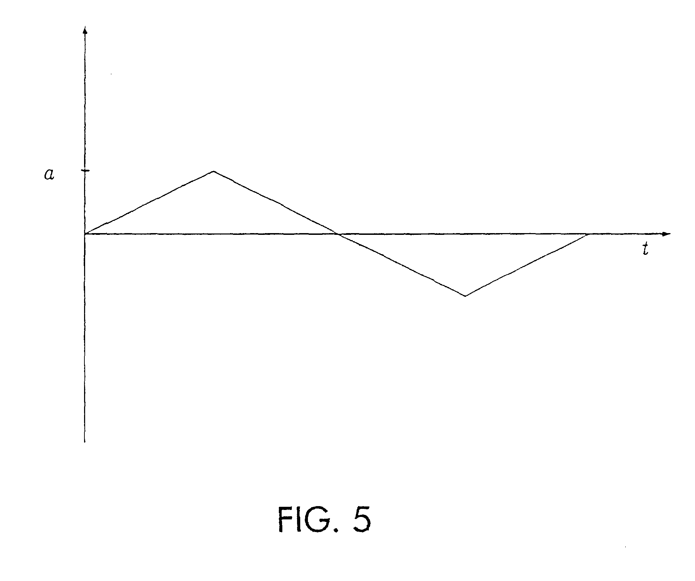

Zunächst soll das Grundsätzliche der hier beschriebenen Methode zur Realisierung in Schaltungsmodulen beschrieben werden. Zur Realisierung wird auf ein entsprechendes Tschebyscheff Modul zurückgegriffen, das heißt auf Schaltungsbausteine, die das Tschebyscheffsche Polynom $T_n(x)$ realisieren, wobei $T_0(x) = 1$, $T_1(x) = x$, $T_{n+1} = 2xT_n(x) - T_{n-1}(x)$. Die Sinus- bzw. Cosinusschwingungen werden durch Anlegen einer dreieckförmigen Schwingung (Fig. 5) der Amplitude $a = \sin(\pi/(2n))$ an ein Tschebyscheffmodul $T_n(x)$ erhalten gemäß der Gleichung

$$\text{(1)}$$

$$T_n\left(\frac{x}{n}\right) \approx T_n\left(\sin\left(\frac{x}{n}\right)\right) \approx \begin{cases} \sin(x) & \text{für } n \equiv 1 \bmod 4 \\ -\cos(x) & \text{für } n \equiv 2 \bmod 4 \\ -\sin(x) & \text{für } n \equiv 3 \bmod 4 \\ \cos(x) & \text{für } n \equiv 0 \bmod 4 \end{cases}$$

Der hierbei auftretende Fehler, der sich leicht berechnen läßt, wird nicht-monoton kleiner für größer werdendes n.

Für n = 2, 3, 4, 5 beträgt der maximale Fehler ca. 15,2%, 1,2%, 4,0% sowie 0,42%.

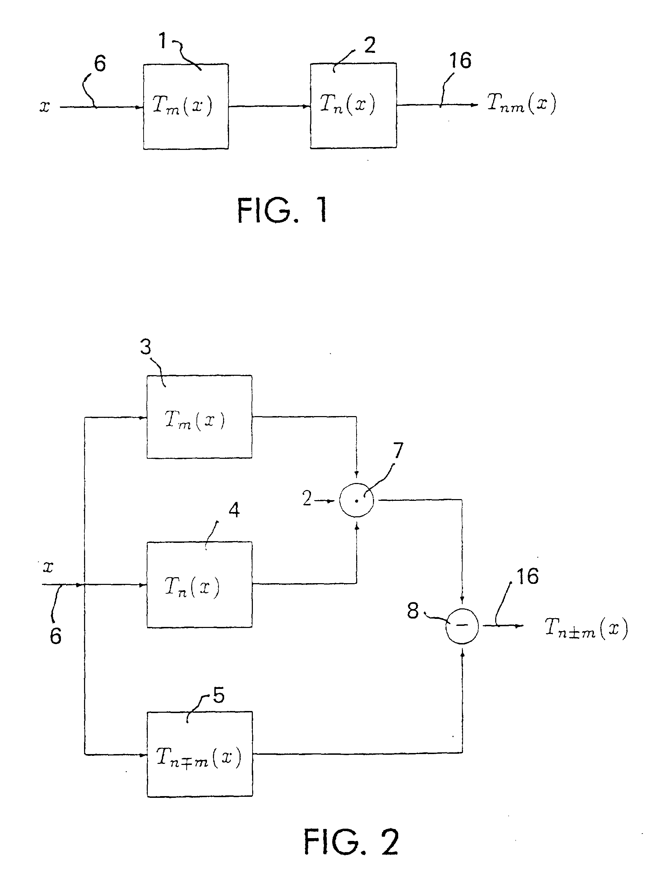

Eine Anwendung von Tschebyscheff Polynomen wird hier zur Erzeugung von Sinus-/Cosinusschwingungen benutzt. Eine Frequenzvervielfacherschaltung nach Figuren 1 bis 4, die um einen geeignet gewählten Arbeitspunkt mit einer Dreieckschwingung, gemäß Fig. 5 am Eingang betrieben, wird angegeben und beschrieben. Ein geeigneter Arbeitspunkt ist der Wert $\varphi 0 = 3 \cdot \pi/2$. Setzt man nämlich in $T_n(\cos(\varphi)) = \cos(n\varphi)$ den Wert $\varphi = \varphi 0 + x$ mit $\varphi 0 = 3\pi/2$, so erhält man

$$T_n(\sin(x)) = \cos\left(\frac{3\pi}{2} \cdot n + n \cdot x\right),$$

woraus sich

$$T_n(\sin(x)) = \begin{cases} \sin(nx) & \text{für } n \equiv 1 \bmod 4 \\ -\cos(nx) & \text{für } n \equiv 2 \bmod 4 \\ -\sin(nx) & \text{für } n \equiv 3 \bmod 4 \\ \cos(nx) & \text{für } n \equiv 0 \bmod 4 \end{cases}$$

ergibt. Ist der Wert von x nicht zu groß, was zum Beispiel der Fall ist für $|x| \leq \pi/(2n)$ wenn n nicht zu klein ist, so gilt in guter Nährung $T_n(x) \approx T_n(\sin(x))$ und somit erhält man

$$T_n\left(\frac{x}{n}\right) \approx T_n\left(\sin\left(\frac{x}{n}\right)\right) = \begin{cases} \sin(x) & \text{für } n \equiv 1 \bmod 4 \\ -\cos(x) & \text{für } n \equiv 2 \bmod 4 \\ -\sin(x) & \text{für } n \equiv 3 \bmod 4 \\ \cos(x) & \text{für } n \equiv 0 \bmod 4 \end{cases}$$

Hiermit folgt, daß mit der in Fig. 5 abgebildeten Dreieckschwingung mit Amplitude

$$a = \sin\left(\frac{\pi}{2n}\right) \approx \frac{\pi}{2n}$$

am Eingang von $T_n(x)$ sich am Ausgang die Approximation einer Sinus/Cosinusschwingung entsprechend der obigen Gleichung ergibt, die mit steigendem n (nicht-monoton) besser wird.

TABELLE 2

| n | 2 | 3 | 4 | 5 | 6 | 7 | 8 | 9 | 10 | 11 | 12 |
|---|---|---|---|---|---|---|---|---|----|----|----|
| Fehler $e_{max}$ | | | | | | | | | | | |
| $e_{max}$ | 15,6% | 1,2% | 4,01% | 0.422% | 1,788% | 0,214% | 1,01% | 0,129% | 0,645% | 0,386% | 0,448% |

In der Tabelle 2 ist der maximale Fehlerwert

$$e_{max}=\max|T_n(x)-T_n(\sin(x))|$$

für x im Intervall [-a, a] angegeben, wobei

$$a=\sin(\tfrac{\pi}{2n}) \approx \tfrac{\pi}{2n}.$$

In der Tabelle 2 für $e_{max}$ spiegelt sich bis zu einem gewissen Grade die Hardwarekomplexität wider, was sich beispeilsweise darin zeigt, daß die Genauigkeit von $T_3(x)$ bei Approximation der Sinus/Cosinusfunktion größer ist als die Genauigkeit von $T_4(x)$. Die Kosten von $T_3$ sind für die Mehrzahl der Anwendungen aufgrund des notwendigen Multiplizierers höher als für zwei Bausteine $T_2$.

Wie bereits erwähnt, sind die Tschebyscheffschen Polynome n-ten Grades $T_n(x)$ definiert durch die Gleichung:

$$T_n(\cos(\varphi)) = \cos(n\varphi),$$

das heißt, gibt man eine Cosinusschwingung als Eingangsgröße in $T_n(x)$, so erhält man am Ausgang der Schaltung die Cosinusschwingung mit n-facher Frequenz. Informationen zu Tschebyscheff Polynomen sind zum Beispiel in "Abramowitz, Stegun: Handbook of Mathematical Functions" angegeben. Die ersten Tschebyscheff Polynome lauten: $T_0(x) = 1$, $T_1(x) = x$, $T_2(x) = 2x^2 - 1$, etc. Sie lassen sich mit Multiplizierern und Addierern bzw. Subtrahierern realisieren. Für die Realisierung beliebiger n besonders hilfreich sind die beiden folgenden Beziehungen

$$T_{n-m}(x) = T_n(T_m(x)) \tag{2}$$

$$T_{n+m}(x) = 2 \cdot T_m(x) \cdot T_n(x) - T_{n-m}(x) \tag{3}$$

Die Schaltungen für die Gleichungen (2) und (3) sind in den Figuren 1 und 2 dargestellt.

Die auf dieser Basis aufgebaute und realisierte Schaltung für Gleichung (2) gemäß Fig. 1 besteht aus zwei hintereinandergeschalteten Tschebyscheffmodulen 1 und 2, wobei an dem Tschebyscheffmodul 1 die anliegende Eingangsgröße mit der Grundfrequenz liegt und am Ausgang des Tschebyscheffmoduls 2 die Ausgangsgröße mit der um n·m vervielfachten Frequenz. Die Realisierung der Gleichung (3) ist in Fig. 2 dargestellt. Diese Schaltung besteht aus den Tschebyscheffmodulen 3, 4 und 5, deren Eingänge alle die Eingangsfrequenz x zugeführt bekommen. Die Ausgänge der Tschebyscheffmodule 3 und 4 sind auf den Eingang eines Multiplizierers 7 geführt, an dessen weiterer Eingang eine 2 zur Multiplikation anliegt. Der Ausgang des Multiplizierers 7 wird mit dem Ausgang des Tschebyscheffmoduls 5 auf einen Subtrahierer 8 geführt, an dessen Ausgang dann die Funktion $T_{n+m}(x)$ gebildet wird.

Zu jedem beliebigen Wert N läßt sich nun das Tschebyscheffmodul $T_N(x)$ aus den Schaltungen der Figuren 1 und 2 zusammensetzen. Dabei ergeben sich je nach N verschiedene Realisierungsmöglichkeiten. Die jeweilige Realisierung ist abhängig von den Kosten jeweils vom Fachmann auszuwählen. Im folgenden wird der Einfachheit halber eine Realisierung mit Hilfe von Operationsverstärkern angenommen. Die angegebenen Schaltungen sind nicht notwendigerweise für jeden Anwendungsfall gleich gut geeignet. Je nach Kosten der benötigten Bauteile sind gegebenenfalls andere Realisierungen ohne weiters möglich und im gegebenen Fall günstiger. Mit Hilfe der hier angegebenen Gleichungen kann der Entwurf aber leicht modifiziert und auf den entsprechenden Anwendungsfall zurechtgeschnitten werden.

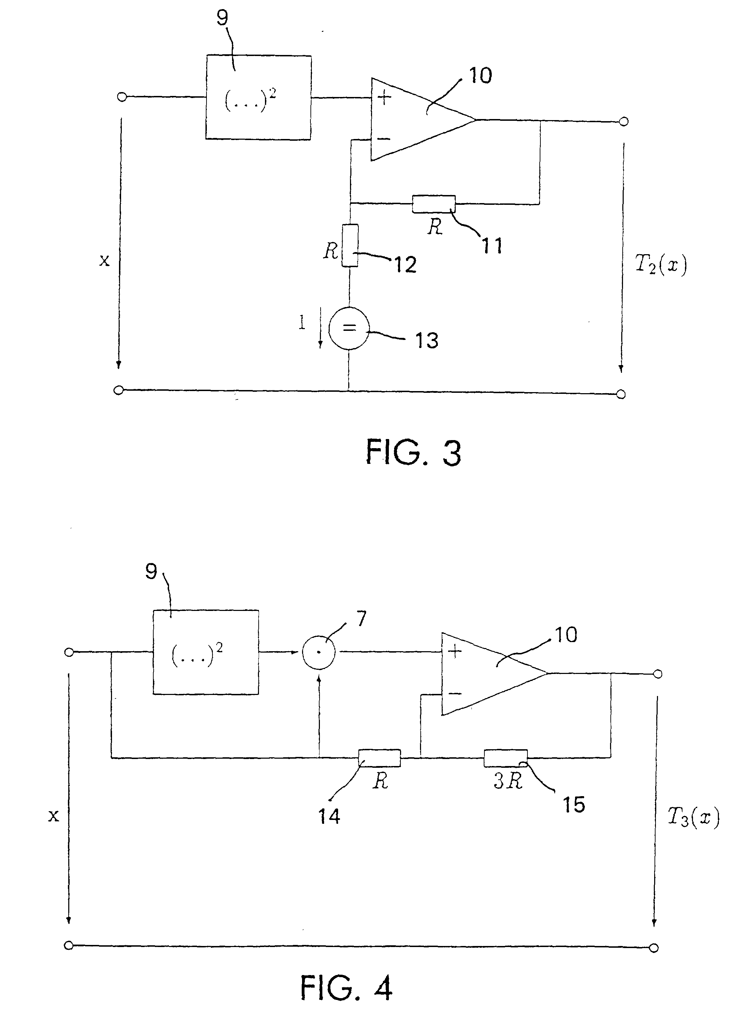

Unter Benutzung der in der Schaltungstechnik bekannten Operationsverstärkerschaltungen erhält man für die ersten nicht trivialen Polynome $T_2(x)$ und $T_3(x)$ die in den Figuren 3 bzw. 4 dargestellten schaltungsmäßige Realisierung bzw. Implementierung. Bezeichnet man mit $K_n$ die Kosten der Realisierung der Funktion $T_n(x)$, so ist aus Fig. 3 zu ersehen, daß das mit Operationsverstärkern implementierte Polynom $T_2$ die Kosten von einem Quadrierer 9, einem Operationsverstärker 10, zwei Widerständen 11 und 12 sowie einer Konstantspannungsquelle 13 verursacht.

Die Schaltung nach Fig. 4 für die Realisierung der Funktion $T_3(x)$ besteht wiederum aus einem Quadrierer 9, einem nachgeschalteten Multiplizierer 7 sowie einem Operationsverstärker 10, dessen Ausgangssignal über einen Spannungsteiler, bestehend aus den Widerständen 14 und 15, auf seinen Eingang rückgekoppelt ist. Am Ausgang dieser Schaltung stehen die entsprechenden elektrischen Größen der Funktion $T_3(x)$ zur Verfügung.

Damit ist gezeigt, daß durch eine derartige Schaltung eine preisgünstige Realisierung von Schaltungen zur Frequenzvervielfachung möglich ist.

Die für die Synthese beliebiger $T_n(x)$ nützlichen Formeln sind die angegebenen Formeln (2) und (3).

**Liste der Bezugszeichen**

| | |
|---|---|
| 1 bis 5 | Tschebyscheffmodule |
| 6 | Schaltungseingang |

| 7 | Multiplizierer |
|---|---|
| 8 | Subtrahierer |
| 9 | Quadrierer |
| 10 | Operationsverstärker |
| 11,12 | Widerstände |
| 13 | Konstantspannungsquelle |
| 14,15 | Widerstände |
| 16 | Schaltungsausgang |

**Patentansprüche**

1. Verfahren zum Erzeugen von Sinus- und/oder Cosinusschwingungen mit Hilfe von elektrischen Schaltungen bzw. programmierbaren oder festprogrammierbaren Schaltungsmodulen, an deren Eingang eine Dreieckschwingung angelegt wird, **dadurch gekennzeichnet,**

   **daß** die Dreieckschwingung an den Eingang eines Tschebyscheffmoduls (1-5) in Form eines programmierbaren oder festprogrammierten Schaltungsmoduls zur Realisierung bzw. Implementierung des Tschebyscheffschen Polynoms $T_n(x)$ gegeben wird und

   **daß** das Tschebyscheffmodul (1-5) Sinus- bzw. Cosinusschwingungen generiert, die je nach der Größe des Wertes n am Ausgang des Tschebyscheffmoduls mit bestimmten Frequenzen zur Verfügung gestellt werden.

2. Verfahren nach Patentanspruch 1, **dadurch gekennzeichnet,**

   **daß** die Dreieckschwingung eine Amplitude a = sin($\pi$/2n)), mit $\pi$ = 3,141... aufweist und

   **daß** die Sinus- oder Cosinusschwingungen in Abhängigkeit vom Wert von n am Ausgang des Schaltungsmoduls vorliegen.

3. Schaltungsanordnung zum Erzeugen von Sinus- und/oder Cosinusschwingungen mit Hilfe von elektrischen Schaltungen bzw. programmierbaren oder festprogrammierbaren Schaltungsmodulen, an deren Eingang eine Dreieckschwingung angelegt wird, **dadurch gekennzeichnet,**
   **daß** das Tschebyscheffmodul (1-5) als Halbleiterchip, insbesondere als programmierbarer Speicherchip ausgeführt ist, an dessen Eingangsleitungen zur Generierung von Sinus-/Cosinusschwingungen eine Dreieck- oder ähnliche Schwingung anliegt.

4. Schaltungsanordnung nach Patentanspruch 3, **dadurch gekennzeichnet,**
   **daß** die Tschebyscheffmodule (1-5) als digitale oder analoge Halbleiterchips und miteinander koppelbar bzw. zusammenschaltbar ausgeführt sind.

**Claims**

1. Process for generating sinusoidal and/or cosinusoidal oscillations using electrical circuits or programmable or fixed-programmable circuit modules, to the inputs of which a delta oscillation is applied, **characterized in that**

   the delta oscillation is applied to the input of a Chebychev module (1-5) in the form of a programmable or fixed-programmed circuit module for realization or implementation of the Chebychev polynomial $T_n(x)$ and

   the Chebychev module (1-5) generates sinusoidal or cosinusoidal oscillations which, depending on the magnitude of the value n, are made available with certain frequencies at the output of the Chebychev module.

2. Process according to claim 1, **characterized in that**

   the delta oscillation has an amplitude n = sin($\pi$/2n)), where $\pi$ = 3.141... and

   the sinusoidal or cosinusoidal oscillations are present at the output of the circuit module as a function of the value of n.

3. Circuit arrangement for generating sinusoidal and/or cosinusoidal oscillations using electrical circuits or programmable or fixed-programmable circuit modules, to the inputs of which a delta oscillation is applied, **characterized in that**
the Chebychev module (1-5) is in the form of a semiconductor chip, especially in the form of a programmable memory chip, to the input lines of which a delta or similar oscillation is applied in order to generate sinusoidal/cosinusoidal oscillations.

4. Circuit arrangement according to claim 3, **characterized in that**
the Chebychev modules (1-5) are in the form of digital or analog semiconductor chips and are couplable or interconnectable.

**Revendications**

1. Procédé de génération d'oscillations sinusoïdales et/ou cosinusoïdales à l'aide de circuits électriques ou de modules programmables ou à programme fixe à l'entrée desquels une oscillation triangulaire est appliquée, **caractérisé en ce que**

l'oscillation triangulaire est appliquée à l'entrée d'un module de Tchebycheff (1-5) sous forme d'un module programmable ou à programme fixe pour la réalisation ou l'implémentation du polynôme de Tchebycheff $T_n$ (x) et

le module de Tchebycheff (1-5) génère des oscillations sinusoïdales ou cosinusoïdales, qui, en fonction de la valeur de n à la sortie du module de Tchebycheff, sont rendues disponibles avec certaines fréquences

2. Procédé selon la revendication 1, **caractérisé en ce que**

l'oscillation triangulaire a une amplitude a = sin($\pi$/2n), avec $\pi$ = 3,141..., et

les oscillations sinusoïdales ou cosinusoïdales se présentent à la sortie du module en fonction de la valeur de n.

3. Montage servant à générer des oscillations sinusoïdales et/ou cosinusoïdales à l'aide de circuits électriques ou de modules programmables ou à programme fixe à l'entrée desquels une oscillation triangulaire est appliquée, **caractérisé en ce que**
le module de Tchebycheff (1-5) se présente sous la forme d'un semi-conducteur (puce), notamment d'une puce mémoire programmable, une oscillation triangulaire ou analogue étant appliquée à ses circuits d'entrée pour la génération d'oscillations sinusoïdales et/ou cosinusoïdales.

4. Montage selon la revendication 3, **caractérisé en ce que**
les modules de Tchebycheff (1-5) se présentent sous la forme de puces électroniques numériques ou analogiques et sont interconnectables entre eux.

FIG. 1

FIG. 2

FIG. 3

FIG. 4

FIG. 5